# EUROPEAN PATENT APPLICATION

(11) **EP 3 955 711 A1**
(43) Date of publication of application: **16.02.2022**
(21) Application number: 20190276.4
(22) Date of filing: 10.08.2020
(51) Int. Cl.: H05K 3/30, H05K 3/32, H05K 3/34, H05K 1/18

(54) **ELECTRONIC SYSTEM AND METHOD**

(71) Applicant: Vestel Elektronik Sanayi ve Ticaret A.S., 45030 Manisa (TR)
(72) Inventor: TOPAÇ, Hamdullah Cihangir, 45030 Manisa (TR)
(74) Representative: Kehl, Ascherl, Liebhoff & Ettmayr Patentanwälte Partnerschaft mbB

(57) **Abstract**

The present invention provides an electronic system (100, 200) comprising a carrier substrate (101, 201) configured to carry electronic devices, the carrier substrate (101, 201) comprising a mounting side (205) and a soldering side (102, 202), a number of electrical devices (103, 203) provided on the soldering side (102, 202) of the carrier substrate (101, 201) and comprising a number of contact legs (206), the contact legs (206) being configured to reach from the mounting side (205) to the soldering side (102, 202) of the carrier substrate (101, 201), and a number of coupling elements (207) provided on the soldering side (102, 202) of the carrier substrate (101, 201), the coupling elements (207) each comprising a number of contacts (208) and the same number of contact receptacles (209) electrically coupled to the contacts (208), the contacts (208) being inserted into openings in the carrier substrate (101, 201) and reaching through to the soldering side (102, 202), wherein the contacts (208) are soldered to the carrier substrate (101, 201) on the soldering side (102, 202) and wherein the contact legs (206) are electrically coupled to the contact receptacles (209). Further, the present invention provides a respective method.

## Description

### TECHNICAL FIELD

The invention relates to an electronic system and a respective method.

### BACKGROUND

Although applicable to any electronic device that must be mounted on the soldering side of a PCB, the present invention will mainly be described in conjunction with display devices that are mounted on the soldering side of a PCB.

In modern electronic devices, especially so called "white goods" devices like e.g. washing machines, ovens and the like, so called electronic control cards are widely used.

Such electronic control cards are usually implemented on a printed circuit board (PCB) and carry electrical components which are soldered onto the PCB. Three production techniques may be used for soldering components on the PCB in the process of production of electronic control cards, wave soldering, cream soldering or a combination of both of them.

Electronic control cards, like e.g. oven timer cards, are usually produced with a single layer PCB to be cost effective. Through-hole devices and high electrical power electrical components, which usually have a large volume, are inevitably used because of the high-power demand of such devices.

The electrical components are usually mounted on the non-conductive surface of the PCB. Legs of these through-hole components are fitted into holes and are wave soldered on the soldering side of the PCB, i.e. the conductive surface of the single layer PCB.

On the other hand, user interface components such as buttons or display devices of the oven control cards must usually be placed on the soldering side or conductive surface, since the electronic control card is usually mounted directly where the user interface is placed. However, soldering of e.g. a display device on the soldering side or conductive surface of the PCB poses different problems. It is for example not possible to cream solder such devices or to apply a wave soldering process. The display devices are usually not high temperature resistant and would be damaged during a wave soldering process.

One of the applied techniques to protect components from heat during a wave soldering process is the use of soldering pallets. However, display devices for example because of their volume are not adequate for use with soldering pallets. The alternative, to produce display devices with increased heat resistance would increase the costs for the display devices.

Therefore, usually devices like display devices or buttons or the like are soldered with an extra process after all other production processes of the PCB are finished. Such devices are then soldered or mounted manually. An additional wave soldering step may also be required. This causes extra labor, apparatus costs, and wastes production time.

Accordingly, there is a need for improving the mounting of large electrical devices on the soldering side of a PCB.

### SUMMARY OF THE INVENTION

The above stated problem is solved by the features of the independent claims. It is understood, that independent claims of a claim category may be formed in analogy to the dependent claims of another claim category.

Accordingly, it is provided:
An electronic system comprising a carrier substrate configured to carry electronic devices, the carrier substrate comprising a mounting side and a soldering side, a number, i.e. one or more, of electrical devices provided on the soldering side of the carrier substrate and comprising a number, i.e. one or more, of contact legs, the contact legs being configured to reach from the mounting side to the soldering side of the carrier substrate, and a number, i.e. one or more, of coupling elements provided on the soldering side of the carrier substrate, the coupling elements each comprising a number of contacts and the same number of contact receptacles electrically coupled to the contacts, the contacts being inserted into openings in the carrier substrate and reaching through to the soldering side, wherein the contacts are soldered to the carrier substrate on the soldering side and wherein the contact legs are electrically coupled to the contact receptacles.

Further, it is provided:
A method for mounting an electronic system according to any one of the previous claims, the method comprising providing a carrier substrate configured to carry electronic devices, the carrier substrate comprising a mounting side and a soldering side, mounting a number of coupling elements on the mounting side, the coupling elements each comprising a number of contacts and contact receptacles, wherein the coupling elements are mounted such that the contacts reach through the carrier substrate to the soldering side, soldering the electrical contacts to the carrier substrate on the soldering side of the carrier substrate, mounting a number of electrical devices on the soldering side of the carrier substrate, wherein the electrical devices comprise a number of contact legs, the contact legs being configured to reach from the mounting side to the soldering side, and electrically coupling the contact legs to the contact receptacles of the coupling elements.

As already explained above, in so called "white goods" electrical systems, like e.g. ovens, usually simple single-sided PCB are used, where most electrical elements are mounted on the non-conducting, also called non-soldering, side of the PCB. However, since for reasons of efficiency, mostly only one such single-sided PCB should be used in an electrical system, the user interface should be placed on the same PCB but on the soldering side. This allows providing all required electrical elements on the non-soldering side and providing e.g. the user interface elements on the smooth (because not cluttered with other elements) soldering side of the PCB.

From the above explanations it can be seen that mounting such user interface elements is usually a complex and error prone, at least in part manual process.

The present invention therefore provides a system and a respective mounting method that allows easily mounting electrical devices on electrical control cards of electronic systems, like e.g. "white goods" systems.

To this end, the electronic system according to the present invention provides a carrier substrate that comprises at least a mounting side and soldering side. Although in this context the carrier substrate is usually referred to as being a single sided PCB, it is understood, that the carrier substrate may also be a two-sided PCB or a multi-layer PCB in some embodiments. In such embodiments, the soldering side is to be understood as that side of the PCB that faces away from the electrical system, e.g. to a user's usual position when interacting with the electronic system.

The carrier substrate may therefore be such an electronic control card of an electrical system, as mentioned above. In the electronic system, the carrier substrate carries an electrical device, e.g. a display device, a button device, a rotary encoder device or the like. It is understood, that any type of electrical element may implement the electrical device in the electronic system, although mostly user interface devices will be mentioned in this context. It is further understood, that the use of the terms "electrical", "electronic" or "electric" does not imply any features of the respective elements or devices.

The electrical device comprises contact legs for electrically contacting the electrical device and coupling the electrical device with the other electrical or electronic components of the electronic system.

However, in the electronic system the electrical devices are not provided on the soldering side of the carrier substrate and soldered to the carrier side or to the mounting side after passing the respective contact legs through the carrier substrate.

Instead, in the electronic system the electrical devices are provided on the soldering side and the carrier substrate comprises coupling elements for the contact legs of the electrical devices. These coupling elements are mounted on the mounting side of the carrier substrate and comprise contacts, and further comprising respective contact receptacles that are each coupled to at least one of the contacts.

The contacts serve to electrically contact the coupling elements and reach through openings in the carrier substrate from the mounting side to the contact side, where the contacts are soldered to the carrier substrate.

Since the coupling elements are provided on the mounting side and the contacts are soldered to the carrier substrate on the soldering side, any of the known soldering methods, like e.g. wave soldering or cream soldering or a combination of both of them may be used to electrically contact the coupling elements. As with other electrical elements, like e.g. resistors, the through-hole mounting technique may also provide a mechanical fixation of the coupling elements on the carrier substrate. In embodiments, at least some of the electrical elements may also comprise additional mechanical fixation.

The contact receptacles each serve to contact one of the contact legs of the electrical devices. To this end, the contact legs of the electrical devices reach from the soldering side of the carrier substrate to the mounting side of the carrier substrate.

On the mounting side, the coupling elements each receive one of the contact legs of the electrical devices and electrically contact the contact legs.

According to the present invention when mounting an electrical system, the carrier substrate is provided. It is understood, that the carrier substrate may be a PCB that is prepared with respective tracks or conducting paths, vias, openings and the like.

On the mounting side of the carrier substrate the coupling elements, and obviously other electronic elements of the electronic system, may be arranged. It is understood, that the coupling elements and the other electronic elements may be so called through-hole devices, which comprise legs that reach through the carrier substrate to the soldering side. This means that all electronic elements of the electronic system but the electronic devices like display devices and user input devices may be mounted as through-hole elements on the mounting side of the carrier substrate. It is understood, that a mix of through-hole and other elements, e.g. SMD elements is also possible on the mounting side. In such embodiments, electrical elements may also be soldered to the mounting side of the carrier substrate.

After placing all the electronic elements including the coupling elements on the mounting side, the electronic elements may be soldered on the soldering side to the carrier substrate. To this end for example a wave soldering process, a cream soldering process or any other adequate soldering process may be used.

After the soldering process, all electronic elements including the coupling elements are therefore electronically, and in most cases also mechanically, coupled to the carrier substrate.

After this soldering process, the electrical devices may be provided on the soldering side. The contact legs of the electrical devices will however reach to the mounting side of the carrier substrate. On the mounting side, the contact legs are then coupled to the contact receptacles, thereby establishing an electrical contact.

It is understood, that the contact receptacles may be of a type that allows fully automatically coupling the contact legs to the respective contact receptacles.

The electrical devices are therefore coupled via the coupling elements to the soldering side of the carrier substrate, without the need to manually solder the contact legs to the carrier substrate.

Therefore, the present invention allows mounting electrical devices like e.g. display units or input devices, like e.g. buttons or knobs, on the soldering side of the carrier substrate, while at the same time allowing a very simple mounting process that does not require manual work.

Further embodiments of the present invention are subject of the further subclaims and of the following description, referring to the drawings.

In an embodiment, the contact legs may be bent to couple to the contact receptacles.

The contact legs of the electrical devices may be bent such that they easily reach the contact receptacles of the coupling elements at the respective position. In this embodiment, after placing the electrical devices on the soldering side of the carrier substrate, the contact legs may e.g. be located such that they hover over the contact receptacles.

Such legs may then be coupled to the contact receptacles easily in an automated process that pushes the contact legs into the contact receptacles.

In a further embodiment, the contact legs may be bent around an edge of the carrier substrate.

Starting from the electrical device, the contact legs may in a mounted position extend parallel to the soldering side and over the edge of the carrier substrate, there the contact legs may be bent in a 90° angel towards the soldering side. After a respective length, after the that 90° bend, the contact legs may then be bent e.g. in another 90° angle or in any other adequate angle, e.g. less than 90°, for example a 30° angle, resulting in a 60° angle between the contact leg and the mounting side, or any angle between 90° and 0°, like e.g. an angle of 45°.

In an embodiment, the contact legs may e.g. all be provided on the same side or edge of a respective electrical device. This means that the electrical device may e.g. be positioned on the soldering side e.g. by a sliding movement from a side of the carrier substrate. Such a movement may be automated by a respective machine easily.

It is understood, that the coupling elements may be provided such that the contact receptacles are placed according to the ends of the contact legs in the final position of the respective electrical device.

In another embodiment, the carrier substrate may comprise a pass-through opening for each one of the contact legs, and the contact legs may reach through the respective pass-through openings.

The pass-through openings are not to be confused with vias on a PCB. The pass-through openings in contrast to vias do not serve any electrical purpose. Instead, the pass-through openings simply provide a mechanical opening for the contact legs to pass through from the soldering side to the contact side.

Therefore, the pass-through openings are mechanically dimensioned to easily let the contact legs pass-through. That means, that the diameter of a pass-through opening will be larger than the diameter of a contact leg.

With pass-through openings, the contact legs may e.g. be provided as straight legs on the electrical devices.

Positioning the electrical devices may in this embodiment easily be performed by lowering the electrical devices in an orthogonal movement onto the soldering side of the carrier substrate.

On the mounting side, the contact legs may then e.g. be bent automatically with a respective machine to be placed with the respective contact receptacles. Depending on the specific contact receptacles, the step of bending may not be necessary, as will be described below.

In a further embodiment, the contact receptacles each may comprise a terminal contact, especially a clamping terminal contact, an insulation displacement contact terminal, also called IDC, or a screwing contact terminal.

Providing the contact receptacles as terminals that allow easily fixing and contacting the contact legs, further reduces the effort for mounting the electrical devices to the carrier substrate.

Especially clamping terminals or IDCs allow mechanically and electrically contacting the respective contact legs simply by pushing them into the respective receptacle.

It is understood, that in another embodiment, the contact receptacles may e.g. provide a welding surface and the contact legs may be welded to the welding surfaces e.g. by laser welding or spot welding. A combination of clamping and welding is also possible in the contact receptacles.

In another further embodiment, the coupling elements may comprise a tilt mechanism, wherein the tilt mechanism may be configured to allow insertion of a respective contact leg in an open state and to electrically and mechanically fix a contact leg in the respective coupling element in a closed state.

A tilt mechanism in an open state allows easily inserting a contact leg. For example, such a mechanism may allow access to a taper- or funnel-like section of the contact receptacles, where the end of the respective contact leg may easily be inserted without the need to provide a very exact positioning of the contact leg.

After closing the tilt mechanism, e.g. after closing a cover that may be part of the tilt mechanism, the taper- or funnel-like section may be covered and the end of the contact leg may be fixed.

It is understood, that the tilt mechanism may also comprise a lock mechanism, that holds the tilt mechanism in the closed state after closing the tilt mechanism.

It is understood, that in some embodiments, the tilt mechanism may also be configured to accept the contact legs through a pass-through opening in the carrier substrate. The tilt mechanism may be configured such that when closing the tilt mechanism, the end of the contact leg may automatically be bent and inserted into and fixed in the respective contact receptacle.

In a further embodiment, the carrier substrate may comprise mounting elements configured to mechanically fix the electrical device to the carrier substrate.

In cases of large electrical devices, especially large compared to the size of the contact legs, the contact legs may not provide enough mechanical stability.

In such cases, the carrier substrate may provide mounting elements for the electrical devices. Such mounting elements may e.g. be respective openings. The electrical devices may comprise respective protrusions that may be inserted into the openings. The protrusions may also comprise clamps or the like that fix the protrusions in the openings.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows a diagram of an embodiment of an electronic system according to the present invention;
- Fig. 2: shows a diagram of another embodiment of an electronic system according to the present invention;
- Fig. 3: shows a further diagram of the embodiment of an electronic system according to the present invention of Fig. 2; and
- Fig. 4: shows a flow diagram of an embodiment of a method according to the present invention.

In the figures like reference signs denote like elements unless stated otherwise.

### DETAILED DESCRIPTION OF THE DRAWINGS

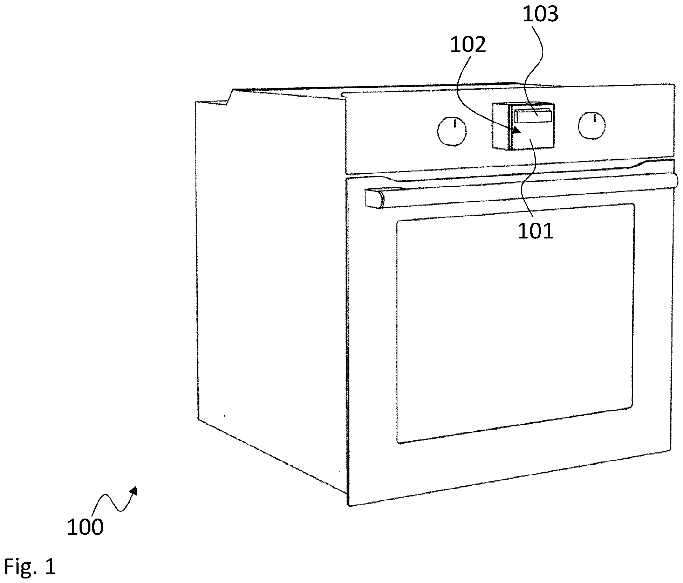

Fig. 1 shows a diagram of an electronic system 100. The electronic system 100 is a kitchen oven that comprises a carrier substrate 101. The carrier substrate 101 is provided on the upper part of the front of the oven and carries on the soldering side 102 an electrical device 103 in the form of a display device 103.

Although not visible, it is understood that the back-side of the carrier substrate 101 that is not visible in Fig. 1 may carry any number and type of further electronic elements. It is also understood, that the soldering side 102 may carry further elements, like e.g. SMD devices or the like.

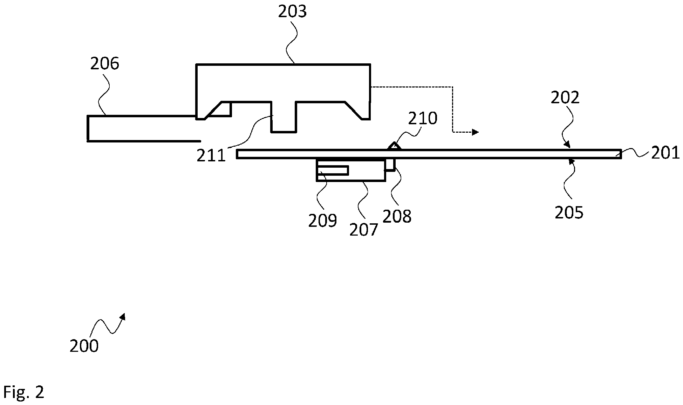

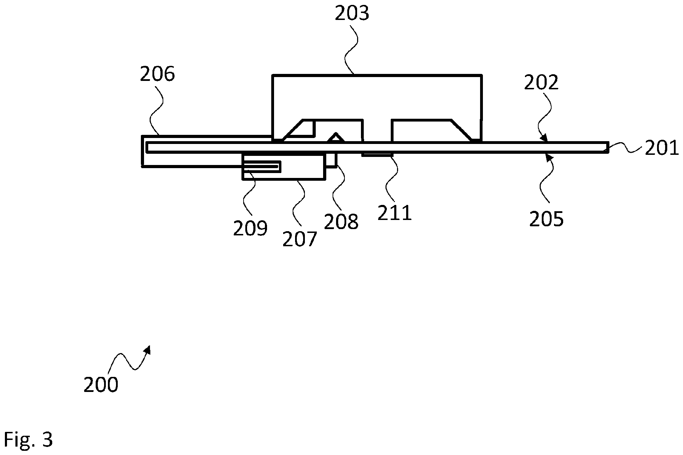

In Figs. 2 and 3 it is explained in detail, how the electrical device 103 may be mounted on the soldering side 102 of the carrier substrate 101 with very little effort according to the present invention.

Fig. 2 shows a diagram of another embodiment of an electronic system 200 in a side view. The electronic system 200 comprises a carrier substrate 201, that extends into the image plane. The upper surface of the carrier substrate 201 is the soldering side 202 of the carrier substrate. The lower surface of the carrier substrate 202 is the mounting side 205, which is not visible in Fig. 1.

On the mounting side 205 of the carrier substrate 201 a coupling element 207 is shown. It is obvious, that although only one coupling element 207 is shown, more coupling elements may be present, e.g. behind the shown coupling element 207.

The coupling element 207 comprises a contact 208 and a contact receptacle 209. The contact 208 extends at one end of the coupling element 207, comprises a 90° bend and then traverses the carrier substrate 201. On the soldering side 202 the contact 208 is soldered at soldering point 210 to the carrier substrate 201. On the other side of the coupling element 207 a contact receptacle 209 is provided.

The electronic system 200 further comprises an electrical device 203, which may e.g. be a display device. The electrical device 203 further comprises a contact leg 206. It is understood, that although only one contact leg 206 is shown, the electrical device 203 may comprise multiple contact legs. The contact leg 206 serves for electrically contacting the electrical device 203.

The contact receptacle 209 of the coupling element 207 is provided to accommodate the contact leg 206 of the electronic device 203. It can be seen that the contact leg 206 is bent in a 90° angle under the electronic device 203 and then extends such that it extends in a mounted position of the electronic device 203 around the edge of the carrier substrate 201 (see Fig. 3). The end section of the contact leg 206 is long enough for the contact leg 206 to reach the contact receptacle 209.

The electronic device 203 further comprises a mechanical fixing element 211. The fixing element 211 serves for mechanically fixing the electronic device 203 to the carrier substrate 201.

Fig. 3 shows another diagram of the electronic system 200 with the electronic device 203 in the final mounted position. In the final mounted position the fixing element 211 is fixed to the carrier substrate 201. The fixing element 211 may e.g. protrude through an opening in the carrier substrate 201 and comprise clamping protrusions, which clamp the electronic system 200 to the carrier substrate 201.

In the final mounted position of the electronic device 203 the contact leg 206 is positioned in the contact receptacle 209. The contact receptacle 209 electrically contacts the contact leg 206 and couples the contact leg 209 electrically to the soldering point 210.

The contact receptacle 209 may e.g. comprise a terminal contact, like e.g. a clamping terminal contact, an insulation displacement contact terminal or a screwing terminal contact. In an alternative embodiment, the coupling element 207 may comprise a tilt mechanism. The tilt mechanism may e.g. allow insertion of the contact leg 206 in an open state and electrically and mechanically fixing the contact leg 206 in the coupling element 207 in a closed state.

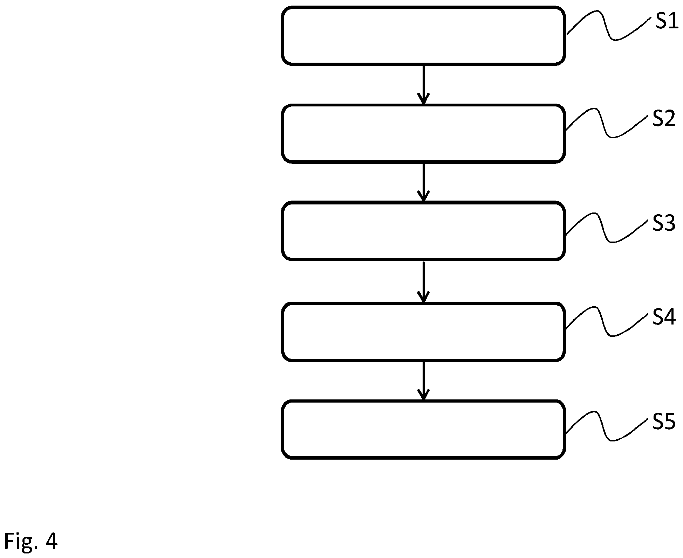

For sake of clarity in the following description of the method-based Fig. 4 the reference signs used above in the description of apparatus-based Figs. 1 - 3 will be maintained.

Fig. 4 shows a flow diagram of an embodiment of a method for mounting an electronic system 100, 200 according to the present invention.

The method comprises providing S1 a carrier substrate 101, 201 configured to carry electronic devices, the carrier substrate 101, 201 comprising a mounting side 205 and a soldering side 102, 202, mounting S2 a number of coupling elements 207 on the mounting side 205, the coupling elements 207 each comprising a number of contacts 208 and contact receptacles 209, wherein the coupling elements 207 are mounted such that the contacts 208 reach through the carrier substrate 101, 201 to the soldering side 102, 202, soldering S3 the contacts 208 to the carrier substrate 101, 201 on the soldering side 102, 202 of the carrier substrate 101, 201, mounting S4 a number of electrical devices 103, 203 on the soldering side 102, 202 of the carrier substrate 101, 201, wherein the electrical devices 103, 203 each comprise a number of contact legs 206, the contact legs 206 being configured to reach from the mounting side 205 to the soldering side 102, 202, and electrically S5 coupling the contact legs 206 to the contact receptacles 209 of the coupling elements 207.

The method may further comprise bending the contact legs 206 to couple to the contact receptacles 209. The contact legs 206 may in an embodiment be bent around an edge of the carrier substrate 101, 201.

The method may also comprise providing a pass-through opening for each one of the contact legs 206 in the carrier substrate 101, 201, and passing the contact legs 206 through the respective pass-through openings.

The contact receptacles 209 may each be provided with a terminal contact, especially a clamping terminal contact, an insulation displacement terminal contact or a screwing terminal contact. Further, the coupling elements 207 may be provided with a tilt mechanism. Such a tilt mechanism allows insertion of a respective contact leg 206 in an open state and electrically and mechanically fixing a contact leg 206 in the respective coupling element 207 in a closed state.

To mechanically fix larger electrical devices 103, 203 mounting elements may be provided in the carrier substrate 101, 201 and mechanically fix the electrical device 103, 203 to the carrier substrate 101, 201 via the mounting elements.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

### List of reference signs

- 100, 200: electronic system
- 101, 201: carrier substrate
- 102, 202: soldering side
- 103, 203: electrical device

- 205: mounting side
- 206: contact leg
- 207: coupling element
- 208: contact
- 209: contact receptacle
- 210: soldering point
- 211: fixing element

- S1, S2, S3, S4, S5, S6: method steps

## Claims

1. Electronic system (100, 200) comprising:
a carrier substrate (101, 201) configured to carry electronic devices, the carrier substrate (101, 201) comprising a mounting side (205) and a soldering side (102, 202),
a number of electrical devices (103, 203) provided on the soldering side (102, 202) of the carrier substrate (101, 201) and comprising a number of contact legs (206), the contact legs (206) being configured to reach from the mounting side (205) to the soldering side (102, 202) of the carrier substrate (101, 201), and
a number of coupling elements (207) provided on the soldering side (102, 202) of the carrier substrate (101, 201), the coupling elements (207) each comprising a number of contacts (208) and the same number of contact receptacles (209) electrically coupled to the contacts (208), the contacts (208) being inserted into openings in the carrier substrate (101, 201) and reaching through to the soldering side (102, 202),
wherein the contacts (208) are soldered to the carrier substrate (101, 201) on the soldering side (102, 202) and wherein the contact legs (206) are electrically coupled to the contact receptacles (209).

2. Electronic system (100, 200) according to claim 1, wherein the contact legs (206) are bent to couple to the contact receptacles (209).

3. Electronic system (100, 200) according to claim 2, wherein the contact legs (206) are bent around an edge of the carrier substrate (101, 201).

4. Electronic system (100, 200) according to any one of the preceding claims 1 and 2, wherein the carrier substrate (101, 201) comprises a pass-through opening for each one of the contact legs (206), and wherein the contact legs (206) reach through the respective pass-through openings.

5. Electronic system (100, 200) according to any one of the preceding claims, wherein the contact receptacles (209) each comprise a terminal contact, especially a clamping terminal contact, an insulation displacement contact terminal or a screwing contact terminal.

6. Electronic system (100, 200) according to any one of the preceding claims, wherein the coupling elements (207) comprise a tilt mechanism, wherein the tilt mechanism is configured to allow insertion of a respective contact leg (206) in an open state and to electrically and mechanically fix a contact leg (206) in the respective coupling element (207) in a closed state.

7. Electronic system (100, 200) according to any one of the preceding claims, wherein the carrier substrate (101, 201) comprises mounting elements configured to mechanically fix the electrical device (103, 203) to the carrier substrate (101, 201).

8. Method for mounting an electronic system (100, 200) according to any one of the previous claims, the method comprising:
providing (S1) a carrier substrate (101, 201) configured to carry electronic devices, the carrier substrate (101, 201) comprising a mounting side (205) and a soldering side (102, 202),
mounting (S2) a number of coupling elements (207) on the mounting side (205), the coupling elements (207) each comprising a number of contacts (208) and contact receptacles (209), wherein the coupling elements (207) are mounted such that the contacts (208) reach through the carrier substrate (101, 201) to the soldering side (102, 202),
soldering (S3) the contacts (208) to the carrier substrate (101, 201) on the soldering side (102, 202) of the carrier substrate (101, 201),
mounting (S4) a number of electrical devices (103, 203) on the soldering side (102, 202) of the carrier substrate (101, 201), wherein the electrical devices (103, 203) comprise a number of contact legs (206), the contact legs (206) being configured to reach from the mounting side (205) to the soldering side (102, 202), and
electrically (S5) coupling the contact legs (206) to the contact receptacles (209) of the coupling elements (207).

9. Method according to claim 8, comprising bending the contact legs (206) to couple to the contact receptacles (209).

10. Method according to claim 9, wherein bending comprises bending the contact legs (206) around an edge of the carrier substrate (101, 201).

11. Method according to any one of the preceding claims 8 and 9, comprising providing a pass-through opening for each one of the contact legs (206) in the carrier substrate (101, 201), and passing the contact legs (206) through the respective pass-through openings.

12. Method according to any one of the preceding claims 8 to 11, providing the contact receptacles (209) each with a terminal contact, especially a clamping terminal contact, an insulation displacement contact terminal or a screwing contact terminal.

13. Method according to any one of the preceding claims 8 to 12, providing the coupling elements (207) with a tilt mechanism, wherein the tilt mechanism allows insertion of a respective contact leg (206) in an open state and electrically and mechanically fixing a contact leg (206) in the respective coupling element (207) in a closed state.

14. Method according to any one of the preceding claims 8 to 13, comprising providing mounting elements in the carrier substrate (101, 201) and mechanically fixing the electrical device (103, 203) to the carrier substrate (101, 201) via the mounting elements.
